# EUROPEAN PATENT APPLICATION

(11) **EP 1 154 498 A2**
(43) Date of publication of application: **14.11.2001**
(21) Application number: 01111567.2
(22) Date of filing: 11.05.2001
(51) Int. Cl.: H01L 51/20, H01L 51/40

(54) **A method of manufacturing a light emitting device**

(30) Priority: 12.05.2000 JP 2000140990
(71) Applicant: SEMICONDUCTOR ENERGY LABORATORY CO., LTD., Atsugi-shi Kanagawa-ken 243-0036 (JP)
(72) Inventor: Yamagata, Hirokazu, Atsugi-shi, Kanagawa-ken 243-0036 (JP); Takahashi, Masahiro, Atsugi-shi, Kanagawa-ken 243-0036 (JP)
(74) Representative: Grünecker, Kinkeldey, Stockmair & Schwanhäusser Anwaltssozietät

(57) **Abstract**

A method of obtaining an excellent luminescence of an EL element having a luminous layer containing a dopant is provided, thereby providing a method of manufacturing a light emitting device containing the EL element with an excellent luminescence, in which a first luminous layer made of a luminous material and a dopant is formed by evaporation, and a second luminous layer made of the luminous material is formed by continuing the evaporation of the luminous material while stopping the evaporation of the dopant. As a result, continuity of the luminous layers is enhanced, whereby an excellent luminescence can be obtained.

## Description

### BACKGROUND OF THE INVENTION

### 1. Field of the Invention

The present invention relates to a light emitting device having an element (hereinafter referred to as EL element) that is comprised of thin films (hereinafter referred to as luminous layers) made of a luminous material that exhibits EL (Electro Luminescence) sandwiched between an anode and a cathode. Note that an organic EL display and an organic light emitting diode (OLED: organic light emitting diode) are included in the light emitting device of the present invention.

Further, the luminous material that can be used in the present invention include all luminous materials that emit light (phosphorescence and/or fluorescence) via a singlet excitation or a triplet excitation, or the both.

Still further, a dopant in the present invention indicates an organic material (organic compound) that becomes a guest, which is doped into a thin film that is made of an organic material and serves as a host. Typically, the dopant refers to an organic material that is doped into the luminous layer for controlling the luminous color thereof. As a dopant doped into the luminous layer, an organic material that emits light (phosphorescence and/or fluorescence) via a singlet excitation or a triplet excitation, or the both, can be used.

### 2. Description of the Related Art

Since the announcement that a light emitting device using a luminous layer made of an organic material emits light under a low driving voltage by Eastman Kodak Corp., the light emitting device using an organic material has been attracting much attention. In the announcement made by Kodak Corp., characterization is directed to fabricating a structure of an element into a lamination type, whereby the driving voltage of the light emitting device can be reduced. Research and development concerning the element structure of a lamination type is being conducted by various companies.

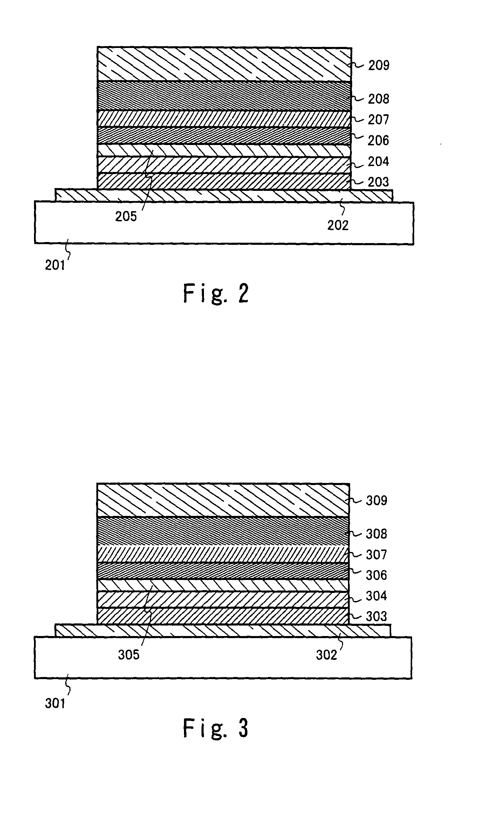

The drawing illustrated in Fig. 2 is a perspective drawing of an experiment (comparative example) conducted by the present inventors, and hence is not a known technique at the time the application of the present invention was made.

In Fig. 2, reference numeral 201 denotes a glass substrate, 202 denotes an anode made of ITO (Indium Tin Oxide), 203 denotes a hole injecting layer (20 nm thick) made of PEDOT (polythiophene), 204 denotes a hole transporting layer (20 nm thick) made of STAD (spiro-triphenylamine derivatives), 205 denotes a hole transporting layer (10 nm thick) made of α-NPD (4,4'-bis[N-(1-naphthyl)-N-phenyl-amino]biphenyl), 206 denotes a luminous layer (10 nm thick) made of SDPVBi (spiro-distyrylbiphenyl) (hereinafter referred to as a blue luminescence layer), 207 denotes a luminous layer (10 nm thick) made of Alq₃ (tris-8-quinolilite-aluminum complex) that is doped with a DCM as a dopant (the luminous layer will hereinafter be referred to as a red luminescence layer), 208 denotes a luminous layer (40 nm thick) made of Alq₃ (hereinafter referred to as a green luminescence layer), and 209 denotes a cathode made of a Yb (ytterbium) film.

At this point, the present inventors performed film deposition of the Alq₃ and the dopant by evaporating them together (an evaporation method in which different materials from dissimilar evaporation sources are vaporized at the same time to thereby mix the materials) to thereby form the red luminescence layer 207. Then the co-evaporation was once halted and only the Alq₃ was evaporated to thereby form the green luminescence layer 208.

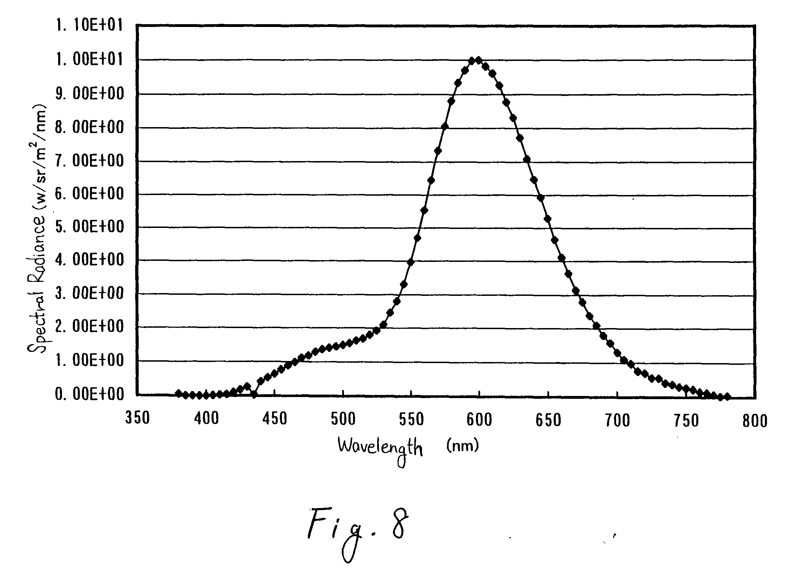

Normally, in the EL element having the lamination structure shown in Fig. 2, blue, red and green colors are mixed altogether to produce white luminescence. However, as shown in Fig. 8, in the above method conducted by the present inventors, the EL element emitted a color having a peak in the vicinity of 600 nm and thus was not able to obtain a fine white color luminescent.

### SUMMARY OF THE INVENTION

The present invention has been made in view of the above problem, and therefore has an object to enhance the continuity of a layer containing a dopant and a layer not containing a dopant when, in forming a thin film made of an organic material, a layer containing a dopant is formed in the thin film.

Typically, an object of the present invention is to provide a method of obtaining an excellent luminescence of an EL element having a luminous layer that contains a dopant, thereby providing a method of manufacturing a light emitting device containing such EL element with an excellent luminescence.

The present inventors conducted various investigations on the manufacturing method of an EL element shown in the light of foregoing experimental results. As a result, the present inventors concluded that an interface between a luminous layer containing a dopant and a luminous layer not containing a dopant significantly influences the luminescing color of the EL element. In other words, the present inventors thought that when the conformity (continuity) in the interface where a luminous layer changes to a different luminous layer is poor, then a white luminescence cannot be attained.

In view of the above, in the element structure shown in Fig. 2, the present inventors performed film deposition of the Alq₃ and an organic material, which is the dopant, by evaporating them together to thereby form the red luminescence layer 207. Then while the evaporation of the Alq₃ is being continued, the evaporation of the dopant is stopped, whereby only the Alq₃ is evaporated to thereby form the green luminescence layer 208.

The structure of an EL element manufactured according to the present invention is shown in Fig. 3. In Fig. 3, reference numeral 301 denotes a glass substrate, 302 denotes an anode made of ITO (Indium Tin Oxide), 303 denotes a hole injecting layer (20 nm thick) made of PEDOT (polythiophene), 304 denotes a hole transporting layer (20 nm thick) made of STAD (spiro-triphenylamine derivatives), 305 denotes a hole transporting layer (10 nm thick) made of α-NPD (4,4'-bis[N-(1-naphthyl)-N-phenyl-amino]biphenyl), 306 denotes a luminous layer (10 nm thick) made of SDPVBi (spiro-distyrylbiphenyl) (hereinafter referred to as a blue luminescence layer), 307 denotes a luminous layer (10 nm thick) made of Alq₃ (tris-8-quinolilite-aluminum complex) that is doped with a DCM as a dopant (the luminous layer will hereinafter be referred to as a red luminescence layer), 308 denotes a luminous layer (40 nm) made of Alq₃ (hereinafter referred to as a green luminescence layer), and 309 denotes a cathode made of a Yb (ytterbium) film.

A characteristic point of the structure of the EL element of the present invention shown in Fig. 3 is that the interface of the red luminescence layer 307 and the green luminescence layer 308 is not a distinct one, but they contact each other in a region having extremely high conformity (continuity). As a result of such an element structure, en excellent white luminescence was obtained from the EL element that was experimented.

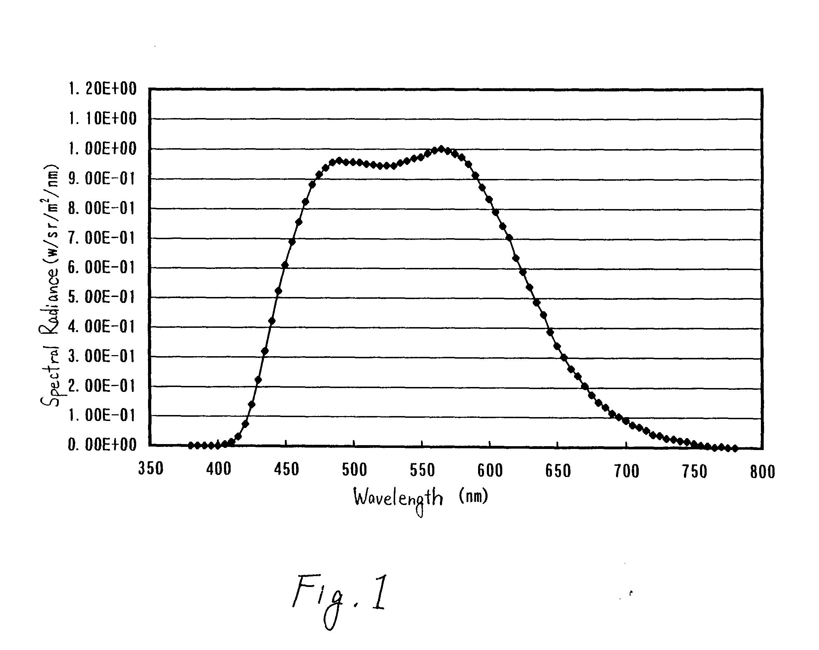

A graph shown in Fig. 1 is a luminance characteristic of the white luminescence obtained by the present invention in which the plots are made with the lateral axis expressing a wavelength and the vertical axis expressing the luminance (spectral radiance) thereof. As shown in Fig. 1, a broad luminance characteristic is obtained in the range of wavelength 400 to 700 nm, and hence is apparent that an excellent white luminescence is obtained.

In the light of the above phenomenon, during the formation of the EL element in which the structure thereof has a luminous layer containing a dopant, the present inventors concluded that it is desirable to form the luminous layers in continuation without stopping the evaporation of the luminous material serving as a host. Particularly, in the case of controlling the luminescing color of the EL element by doping a dopant in the luminous material that forms the luminous layer, the present inventors considered it desirable to continue the evaporation of the luminous material even when stopping or starting the evaporation of the dopant.

Thus, the method of manufacturing the light emitting device of the present invention is characterized in forming the EL element by evaporating the luminous material and the dopant to form the luminous layers, and then with the evaporation of the luminous material in continuation, the evaporation of the dopant is stopped to thereby form the luminous layer made of the luminous material.

In the method of manufacturing the light emitting device of the present invention, the manufacturing method thereof is further characterized in forming the EL element by forming a first luminous layer made of a luminous material by evaporation, and then with the evaporation of the luminous material in continuation, the dopant is evaporated to thereby form a second luminous layer made of the luminous material and the dopant.

By employing the above method of manufacturing an EL element, it is possible to manufacture a passive matrix type light emitting device or an active matrix type light emitting device in which an excellent luminescence can be obtained.

Note that the application of the present invention is not limited to the case of laminating the luminous layer containing a dopant and the luminous layer not containing a dopant. In other words, when forming a thin film made of an organic material, the present invention can be implemented in all the cases where a layer containing a dopant is formed in the thin film. As a result, the continuity of the layer containing a dopant and the layer not containing a dopant is enhanced, whereby the improvement in a luminance characteristic, a characteristic of an electric charge injection or an electric charge transportation can be expected.

### BRIEF DESCRIPTION OF THE DRAWINGS

The above and other objects and features of the present invention will be more apparent from the following description taken in conjunction with the accompanying drawings:
Fig. 1 is a graph showing a luminance characteristic of an EL element (a case where the present invention is employed);
Fig. 2 is a diagram showing a structure of an EL element (a case where the present invention is employed);
Fig. 3 is a diagram showing a structure of an EL element (a case where the present invention is employed);
Figs. 4A to 4E are diagrams showing a manufacturing process of a light emitting device;
Figs. 5A to 5E are diagrams showing a manufacturing process of a light emitting device;
Figs. 6A to 6C are diagrams showing a manufacturing process of a light emitting device;
Fig. 7 is a diagram showing a substitute photograph of a display image of a light emitting device; and
Fig. 8 is a graph showing a luminance characteristic of an EL element (a case where the present invention is not employed).
Figs. 9A to 9F are diagrams showing electronic devices.

### DETAILED DESCRIPTION OF THE PREFERRED EMBODIMENTS

An embodiment mode of the present invention will be explained detail in the embodiments shown in the following.

### Embodiment 1

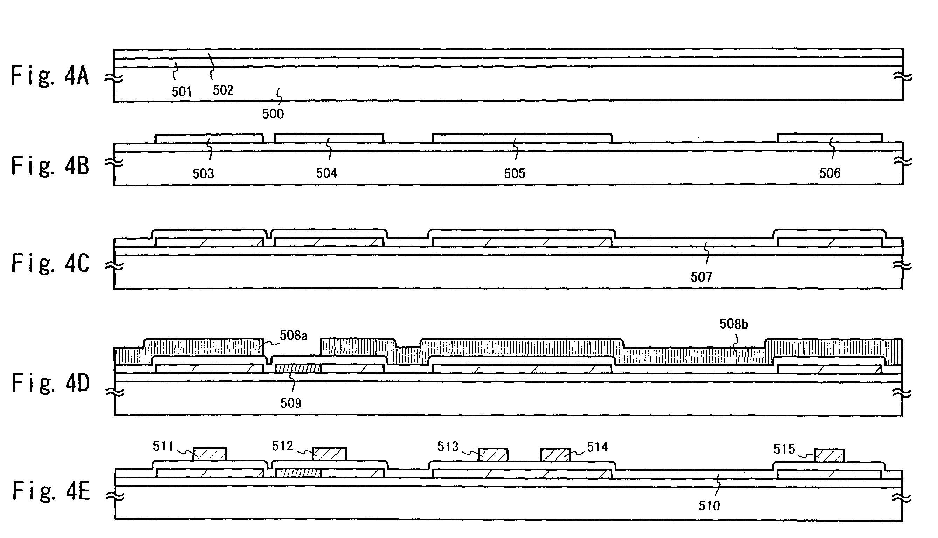

Embodiment 1 of the present invention will be explained with reference to Figs. 4A to 6C. In Embodiment 1, a method of manufacturing a pixel portion and a TFT of a driver circuit portion provided in the periphery thereof at the same time will be described. However, regarding the driver circuit, a CMOS circuit that is a basic unit will be shown in the drawings in order to simplify the description thereof.

First, as shown in Fig. 4A, a base film 501 made of a silicon oxide nitride film is formed with a thickness of 300 nm on a glass substrate 500. At this point, the silicon oxide nitride film is formed into two layers, and the nitrogen concentration of the layer that is in contact with the glass substrate 500 is set relatively high at 10 to 25 wt%.

Next, an amorphous silicon film (not shown in the drawing) is formed with a thickness of 50 nm on the base film 501 by a plasma CVD method. Then the amorphous silicon film is crystallized in accordance with the crystallization technique disclosed in Japanese Patent Application Laid-open No. Hei 7-130652 to thereby form a crystalline silicon film 502 (also referred as a polycrystalline silicon film or a poly-silicon film). (See Fig. 4A)

Next, as shown in Fig. 4B, the crystalline silicon film 502 is patterned to thereby form semiconductor films 503 to 506, which are processed into island-like shapes. (See Fig. 4B)

A protecting film 507 made of a silicon oxide film is next formed with a thickness of 130 nm on the crystalline silicon film 502. Then boron is doped into the semiconductor film 503 to 506 through the protecting film 507. In Embodiment 1, boron is doped by using the plasma doping method in which mass separation is not performed. Through this process, boron is contained in the semiconductor films 503 to 506 at a concentration of between 1 x 10¹⁵ and 5 x 10¹⁷ atoms/cm³. The boron that is doped here is used to regulate a threshold voltage of the TFT. (See Fig. 4C)

Subsequently, resist masks 508a and 508b are formed on the protecting film 507 and then phosphorus is doped through the protecting film 507. In Embodiment 1, phosphorus is doped by using the plasma doping method. Through this process, a semiconductor region (n-type impurity region) 509 is formed to contain phosphorus at a concentration of between 2 x 10¹⁶ and 5 x 10¹⁹ atoms/cm³. (See Fig. 4D)

As shown in Fig. 4E, a gate insulating film 510 is formed next by a plasma CVD method to cover the semiconductor films 503 to 506. A 100 nm thick silicon oxide nitride film is used as the gate insulating film 510.

Next, a lamination film that is composed of a 50 nm thick tantalum oxide (TaN) film and a 350 nm thick tantalum (Ta) film is formed and then patterned to thereby form gate electrodes 511 to 515. At this point, the gate electrode 512 is formed to overlap a portion of the n-type impurity region 509 via the gate insulating film 510.

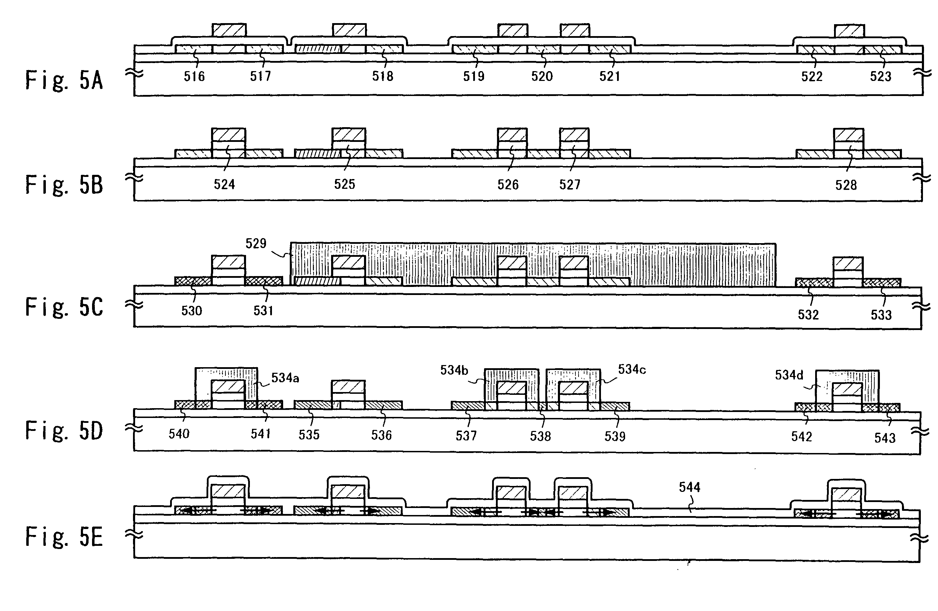

As shown in Fig. 5A, phosphorus is doped in a self-aligning manner at a concentration of between 1 x 10¹⁶ and 5 x 10¹⁸ atoms/cm³ with the gate electrodes 511 to 515 as masks. Impurity regions 516 to 523 thus formed are doped with phosphorus at a concentration that is 1/2 to 1/10 relative to that of the n-type impurity region 509.

Next, as shown in Fig. 5B, the gate insulating film 507 is etched in a self-aligning manner using the gate electrodes 511 to 515 as masks. In Embodiment 1, dry etching is performed by using CHF₃ gas, thereby forming gate insulating films 524 to 528.

A resist mask 529 is formed next as shown in Fig. 5C, and then boron is doped so that the concentration thereof is between 3 x 10²⁰ and 3 x 10²¹ atoms/cm³ to thereby form impurity regions 530 to 533 containing a high concentration of boron. Note that although phosphorus has already been doped in the impurity regions 530 to 533, the concentration of boron that is doped here is at least 30 times or more higher than that of phosphorus. Therefore, the n-type impurity region that was formed in advance completely inverts to the p-type conductivity and functions as a p-type impurity region.

Next, as shown in Fig. 5D, resist masks 534a to 534d are formed and then phosphorus is doped so that the concentration thereof is between 1 x 10²⁰ and 1 x 10²¹ atoms/cm³ to thereby form impurity regions 535 to 539 containing a high concentration of phosphorus. It is to be noted that among the impurity regions 530 to 533, although phosphorus is similarly doped into regions denoted by the reference numerals 540 to 543, the concentration of phosphorus therein is sufficiently low in comparison with the concentration in the p-type impurity region, and thus will not invert from the p-type conductivity to the n-type conductivity.

Then, after removing the resist masks 534a to 534d, a 200 nm thick silicon oxide nitride film is formed as a protecting film 544, and thereafter activation of phosphorus or boron that was doped is conducted. In Embodiment 1, activation is carried out by performing heat treatment in an electric furnace under a nitrogen atmosphere at a temperature of 550°C for 4 hours. During this treatment, because the nickel that was used in the crystallization process will move in the direction indicated by an arrow, it is possible to reduce the concentration of nickel in the region where a channel is to be formed later. In addition, after this heat treatment, heat treatment is performed under an atmosphere containing hydrogen at a temperature of 350°C for 1 hour to thereby perform a hydrogenation process. (See Fig. 5E)

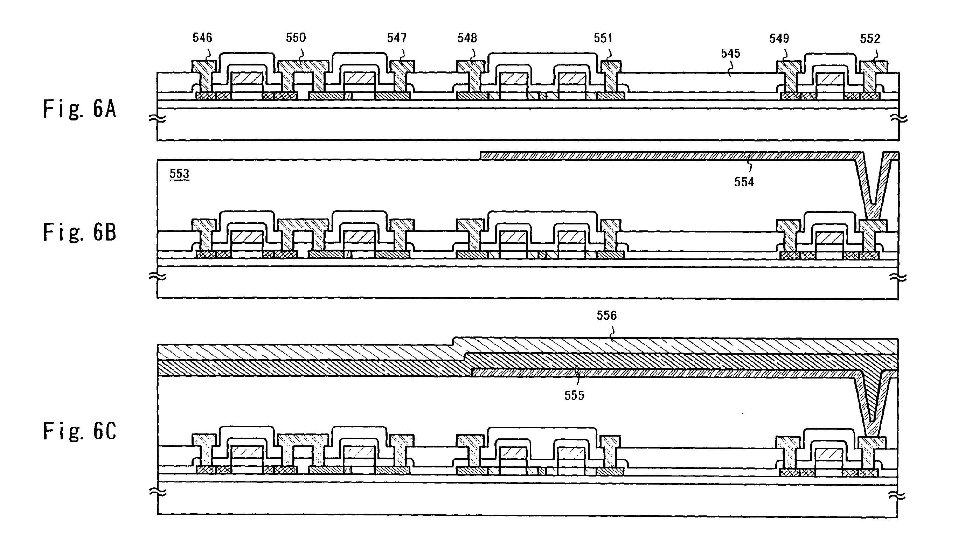

As shown in Fig. 6A, a first interlayer insulating film 545 is formed next. A structure in which a 500 nm thick silicon oxide film laminated on the protecting film 544 is used in Embodiment 1. Then, a contact hole is formed in the first interlayer insulating film 545 to thereby form source wirings 546 to 549 and drain wirings 550 to 552. It is to be noted that in Embodiment 1, this electrode is formed as a lamination film having a four-layered structure that is composed of a 60 nm thick titanium film, a 40 nm thick titanium nitride film, a 300 nm thick aluminum film containing 2 wt% of silicon, and a 100 nm thick titanium film, all formed by sputtering in succession.

Next, as shown in Fig. 6B, a second interlayer insulating film 553 made from an organic resin is formed. In Embodiment 1, an acrylic resin film formed with a thickness of 1.5 µm is formed as the second interlayer insulating film 553. A contact hole is formed in the second interlayer insulating film 553 to reach the drain wiring 552, thereby forming a pixel electrode 554 that is made of an oxide conductive film. An oxide conductive film made from a compound of indium oxide and tin oxide is formed with a thickness of 110 nm as the pixel electrode 554 in Embodiment 1.

Thereafter, ozone treatment is performed on the surface of the pixel electrode 554. In Embodiment 1, this treatment is performed by irradiating ultraviolet rays (UV rays) to the surface thereof under a state where the pixel electrode is exposed in oxygen gas.

Then an EL layer 555 is formed by implementing the present invention. In Embodiment 1, the EL layer 555 is formed taking a lamination structure in which a hole injecting layer (20 nm thick) made of PEDOT (polythiophene), a hole transporting layer (20 nm thick) made of STAD (spiro-triphenylamine derivatives), a luminous layer (10 nm thick) made of SDPVBi (spiro-distyrylbiphenyl), a hole transporting layer (10 nm thick) made of α -NPD (4,4'-bis[N-(1-naphthyl)-N-phenyl-amino]biphenyl), a luminous layer (10 nm thick) made of Alq₃ (tris-8-quinolilite-aluminum complex) that is doped with a DCM as a dopant, and a luminous layer (10 nm thick) made of Alq₃ are formed in succession.

Note that in the foregoing structure, PAni can be substituted with the PEDOT. Also, the dopant is not limited to the DCM, but any materials can be used if it is an organic material showing red fluorescence.

Note that in the present invention, after the formation of the luminous layer made of Alq₃ (tris-8-quinolilite-aluminum complex) that is doped with a dopant, the luminous layer made of Alq₃ is formed without stopping the evaporation of Alq₃ but stopping only that of the dopant.

The present invention has the effect of blurring the boundary between the luminous layer made of the dopant and Alq₃ (the first luminous layer) and the luminous layer made of Alq₃ (the second luminous layer), thereby forming an element structure such as the one shown in Fig. 3. In other words, the continuity of the first luminous layer and the second luminous layer is enhanced. The present inventors assumed that the difference between the actually measured data shown in Fig. 1 and the actually measured data shown in Fig. 8 is due to difference in the continuity of the luminous layers.

Next, a cathode 559 made of a metallic film (specifically, a ytterbium film) is formed into a thickness of 400 nm by evaporation. Thus, an active matrix substrate of a structure as shown in Fig. 6C is completed. In Embodiment 1, an ultraviolet cured resin film is applied on top of the active matrix substrate shown in Fig. 6C, and then after bonding the glass substrate thereto, the ultraviolet cured resin is cured to thereby seal the EL element.

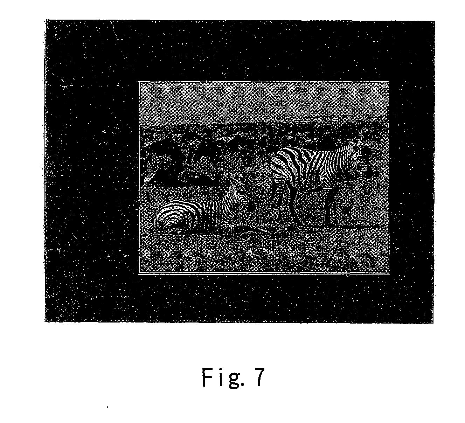

A flexible printed circuit (FPC) is further attached to the active matrix substrate, thereby completing the light emitting device. A display image of the light emitting device manufactured in accordance with Embodiment 1 is shown in Fig. 7. An active matrix type light emitting device in which satisfactory white luminescence is obtained was thus manufactured.

### Embodiment 2

The method of manufacturing an EL element of the present invention can also be employed in a method of manufacturing a passive matrix type light emitting device. The present invention is different from the known method of manufacturing the passive matrix type light emitting device only with respect to the portion of forming the EL element. When forming the luminous layers, an effect of the present invention can be attained if the luminous layers are formed in accordance with the present invention.

### Embodiment 3

In the active matrix type light emitting device illustrated in Embodiment 1, respective elements are formed of planar TFTs. However, the respective elements may be formed of bottom gate TFTs (typically an inverted type TFT). In that case, a crystalline silicon film or an amorphous silicon film may be used as the active layer. Thus, the present invention is characterized by the manufacturing processes of the EL element, and hence there is no limitation placed on the structure of the TFTs.

### Embodiment 4

In Embodiment 1, a known organic material showing red fluorescence can be used as the dopant to be doped into the red luminescence layer. In addition, an organic material showing red phosphorescence may also be used.

Note that the constitution of Embodiment 4 can be implemented by combining it with any of the constitutions of Embodiments 1 to 3.

### Embodiment 5

In Embodiment 1, an organic material having a function to reduce a hole injection barrier can be used as the hole injection layer. A conductive polymer is used as the hole injection layer in Embodiment 5. More specifically, polyacetylene doped with iodine can be used, and furthermore bromine may be used instead of iodine.

Note that the constitution of Embodiment 5 can be implemented by combining it with any of the constitutions of Embodiments 1 to 4.

### Embodiment 6

In the present invention, the utilization of a luminance material as a luminance layer, in which phosphorescence from a triplet excitation can be used for light emission, allows an external light emission quantum efficiency to be remarkably improved. As a result, the EL element can have reduced electric power consumption, a longer life time and reduced weight. The report for an improved external light emission quantum efficiency by using a triplet excitation is described below (T. Tsutsui, C. Adachi, S. Saito, Photochemical Processes in Organized Molecular Systems, ed. K. Honda, (Elsevier Sci. Pub., Tokyo, 1991) p.437).

A molecular formula of an organic material (coumarin pigment) reported by the above paper is shown below.

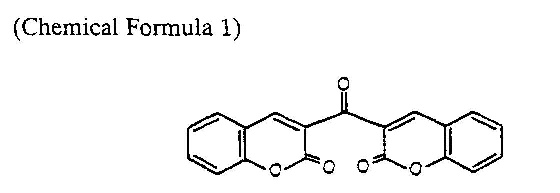

(M. A. Baldo, D. F. O' Brien, Y. You, A. Shoustikov, S. Sibley, M. E. Thompson, S. R. Forrest, Nature 395 (1998), p.151)

A molecular formula of an organic material (Pt complex) reported by the above paper is shown below.

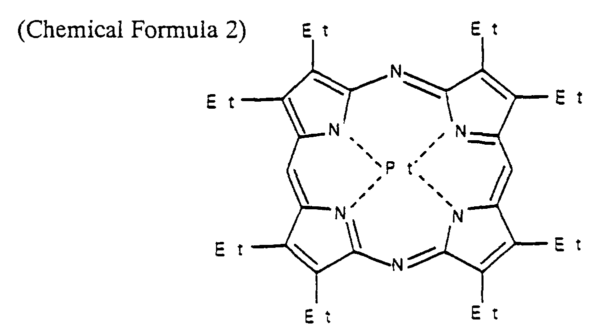

(M. A. Baldo, S. Lamansky, P. E. Burrrows, M. E. Thompson, S. R. Forrest. Appl. Phys. Lett., 75 (1999) p.4), (T. Tsutsui, M.-J. Yang, M. Yahiro, K. Nakamura, T. Watanabe, T. Tsuji, Y. Fukuda, T. Wakimoto, S. Mayaguchi, Jpn. Appl. Phys., 38 (12B) (1999) L1502.).

A molecular formula of an organic material (Ir complex) reported by the above papers is shown below.

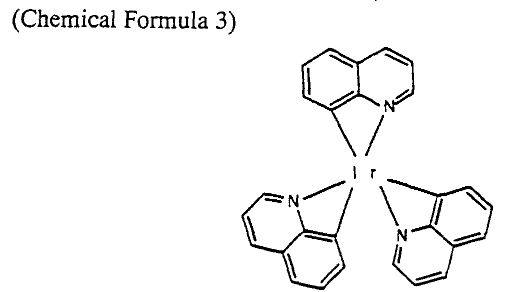

As described above, if phosphorescence emission from a triplet excitation can be utilized, an external light emission quantum efficiency three to four times higher than that with fluorescence emission from a singlet excitation can be theoretically realized.

The structure of this embodiment can be carried out with free combination with any structure of Embodiments 1 to 5.

### Embodiment 7

The light emitting device fabricated in accordance with the present invention is of the self-emission type, and thus exhibits more excellent recognizability of the displayed image in a light place as compared to the liquid crystal display device. Furthermore, the light emitting device has a wider viewing angle. Accordingly, the light emitting device can be applied to a display portion in various electronic devices.

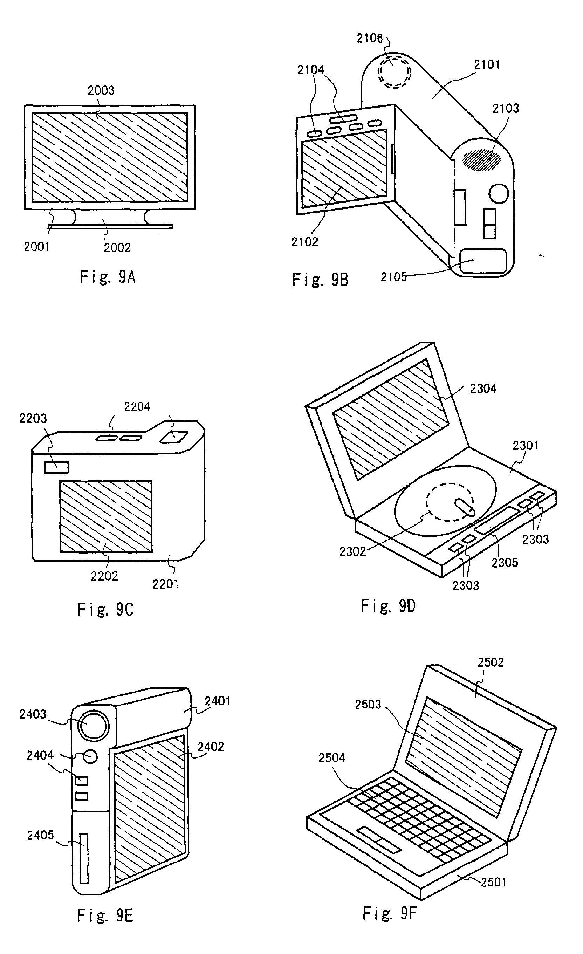

As electronic devices of the present invention there are: a video camera; a digital camera; a goggle type display (head mounted display); a car navigation system; a sound reproduction apparatus (a car audio stereo or an audio stereo and so forth); a notebook type personal computer; a game apparatus; a portable information terminal (such as a mobile computer, a portable telephone, a portable game machine, or an electronic book); and an image playback device equipped with a recording medium (specifically, device provided with a display portion which plays back images in a recording medium such as a digital versatile disk player (DVD), and displays the images). Specific examples of those electronic equipments are shown in Figs. 9A to 9F.

Fig. 9A shows an electro luminescence display device containing a casing 2001, a support stand 2002, and a display portion 2003. The light emitting device of the present invention can be used as the display portion 2003. Such a light emitting display is a self light emitting type so that a back light is not necessary. Thus, the display portion can be made thinner than that of a liquid crystal display.

Fig. 9B shows a video camera, and contains a main body 2101, a display portion 2102, a sound input portion 2103, operation switches 2104, a battery 2105, and an image receiving portion 2106. The light emitting device of the present invention can be used as the display portion 2102.

Fig. 9C illustrates a digital still camera, and contains a main body 2201, a display portion 2202, an ocular portion 2203, and a operation switches 2204. The light emitting device of the present invention is applicable to the display portion 2202.

Fig. 9D is an image playback device equipped with a recording medium (specifically, a DVD playback device), and contains a main body 2301, a recording medium (such as a DVD and so forth) 2302, operation switches 2303, a display portion (a) 2304, and a display portion (b) 2305. The display portion (a) 2304 is mainly used for displaying image information. The display portion (b) 2305 is mainly used for displaying character information. The light emitting device of the present invention can be used as the display portion (a) 2304 and as the display portion (b) 2305. Note that the image playback device equipped with the recording medium includes devices such as game machines.

Fig. 9E shows a portable (mobile) computer, and contains a main body 2401, a display portion 2402, an image receiving portion 2403, and operation switches 2404, and a memory slot 2405. The light emitting device of the present invention is applicable to the display device 2402. Also, in this portable computer, information can be recorded in a recording medium in which flash memories and/or non-volatile memories are integrated, and/or replayed.

Fig. 9F is a personal computer, and contains a main body 2501, a casing 2502, a display portion 2503, and a keyboard 2504. The light emitting device of the present invention can be used as the display portion 2503.

Further, the above electric devices display often information transmitted through an electronic communication circuit such as the Internet and CATV (cable tv), and particularly situations of displaying moving images is increasing. The response speed of organic compound materials is so high that the above electric devices are good for display of moving image.

In addition, since the light emitting device conserves power in the light emitting portion, it is preferable to display information so as to make the light emitting portion as small as possible. Consequently, when using the light emitting device in a display portion mainly for character information, such as in a portable information terminal, in particular a portable telephone or an audio stereo, it is preferable to drive the light emitting device so as to form character information by the light emitting portions while non-light emitting portions are set as background.

As described above, the application range of this invention is extremely wide, and it may be used for electric devices in various fields. Further, the electric device of this embodiment may be obtained by using a light emitting device freely combining the structures of the first to thirteenth embodiments.

A light emitting device having an EL element that exhibits an excellent luminescence can be manufactured by implementing the present invention. As a result, it becomes possible to manufacture the electronic devices having a bright display portion.

## Claims

1. A method of manufacturing a light emitting device, comprising the steps of:
forming a first thin film made of an organic material and a dopant by evaporation; and
forming a second thin film made of the organic material by stopping the evaporation of the dopant while continuing the evaporation of the organic material.

2. A method of manufacturing a light emitting device, comprising the steps of:
forming a first thin film made of an organic material by evaporation; and
forming a second thin film made of the organic material and a dopant by evaporating the dopant while continuing the evaporation of the organic material.

3. A method of manufacturing a light emitting device, comprising the steps of:
forming a first luminous layer made of a luminous material and a dopant by evaporation; and
forming a second luminous layer made of the luminous material by stopping the evaporation of the dopant while continuing the evaporation of the luminous material.

4. A method of manufacturing a light emitting device, comprising the steps of:
forming a first luminous layer made of a luminous material by evaporation; and
forming a second luminous layer made of the luminous material and a dopant by evaporating the dopant while continuing the evaporation of the luminous material.

5. A method of manufacturing a light emitting device, comprising the steps of:
forming a red luminous layer made of a luminous material and a dopant by evaporation; and
forming a green luminous layer made of the luminous material by stopping the evaporation of the dopant while continuing the evaporation of the luminous material.

6. A method of manufacturing a light emitting device, comprising the steps of:
forming a green luminous layer made of a luminous material by evaporation; and
forming a red luminous layer made of the luminous material and a dopant by evaporating the dopant while continuing the evaporation of the luminous material.

7. A method of manufacturing a light emitting device according to any one of claims 1 to 4, wherein a metallic film is formed on the second luminous layer.

8. A method of manufacturing a light emitting device according to any one of claims 1 to 6, wherein the luminous material is Alq₃ (tris-8-quinolilite-aluminum complex).

9. A method of manufacturing a light emitting device according to any one of claims 1 to 6, wherein the dopant is an organic material showing fluorescence.

10. A method of manufacturing a light emitting device according to any one of claims 1 to 6, wherein the dopant is an organic material showing phosphorescence.

11. A method of manufacturing a light emitting device according to any one of claims 1 to 6, wherein said light emitting device is incorporated into an electronic device selected form the group consisting of a video camera, a digital camera; a goggle type display, a car navigation system, a sound reproduction, a notebook type personal computer; a game apparatus, a portable information terminal, and an image playback device.
